Europäisches Patentamt

European Patent Office

Office européen des brevets

(11) Publication number: **0 045 909**
**B1**

(12) **EUROPEAN PATENT SPECIFICATION**

(45) Date of publication of patent specification: 24.04.85

(51) Int. Cl.⁴: **H 05 K 3/34, B 23 K 1/08**

(21) Application number: **81106012.8**

(22) Date of filing: **30.07.81**

(54) **A soldering method and apparatus.**

(30) Priority: 01.08.80 JP 105107/80
08.01.81 JP 533/81
10.04.81 JP 53040/81

(43) Date of publication of application:
17.02.82 Bulletin 82/07

(45) Publication of the grant of the patent:
24.04.85 Bulletin 85/17

(84) Designated Contracting States:
BE CH DE FR LI NL

(56) References cited:
GB-A-1 352 746
US-A-4 093 113
US-A-4 139 881

(73) Proprietor: AIWA CO., LTD.
no. 9, 2-chome, Kanda-Suda-cho
Chiyoda-ku Tokyo (JP)

(72) Inventor: Tsuchikura, Katsuhiko
Kanasugi Center No. 14-2, 3-chome
Shitaya Taito-ku Tokyo (JP)
Inventor: Matsuura, Macoto
Kanasugi Center No. 14-2, 3-chome
Shitaya Taito-ku Tokyo (JP)
Inventor: Kanno, Akira
Iwate Kojo Dai-5 Chiwari-Aza-Myodo
Matabeshinden
Yahaba-cho Shiha-gun Iwate-ken (JP)

(74) Representative: Schmidt, Horst, Dr. et al
Patentanwälte Pohlmann & Schmidt
Siegfriedstrasse 8
D-8000 München 40 (DE)

Courier Press, Leamington Spa, England.

## Description

The present invention relates to a soldering method and apparatus, particularly for soldering electric and or electronic components to a printed-circuit board using a pool of molten solder.

From GB—A—1 352 746 is known a soldering method wherein printed circuit boards are conveyed over a standing solder wave having a flow of inert gas over at least a part of its exposed surface.

From US—A—4 139 881 is known that electric and/or electronic components such as condensers, resistors, transistors and the like temporarily bonded to a printed-circuit board are soldered to the circuit board by dipping its circuit surface into a static pool of molten solder. In such a soldering system, generation of flux gas and gas from the printed-circuit board itself takes place during soldering operation and the gases tend to accumulate around terminal portions of the components to be soldered. The accumulated gases interfere with uniform soldering of the components to the circuit board. Particularly, soldering of chip type components to the circuit board is significantly affected by accumulation of the flux gas around the components. In order to eliminate this disadvantage, it has been practice that vent holes are formed in the printed circuit board adjacent terminal portions of the chip components to be soldered. The existence of the vent holes results in a restriction of circuits to be formed on the other surface of the board, preventing circuits from being highly concentrated. Moreover, formation of the vent holes in the circuit board results in a high cost and a reduction in strength of the board.

An attempt has been made to expel the accumulated gases out of the terminal portions of the chip components by means of high speed jet flow of molten solder towards the components. Such a soldering system is successfully applied to relatively thin flat chip components, but still there is a need for formation of vent holes to effect complete expelling of the gases in case that this soldering system is applied to large cylindrical chip components normally called metal electrode facebonding type components and mould type-transistors. Moreover, this soldering system has a disadvantage that because of generation of waves on the top surface of the molten solder, air is involved in the molten solder to oxidize it, thereby forming undesirable solder dross on the top surface of molten solder.

Accordingly, a main object of the present invention is to provide a novel soldering method and apparatus eliminating disadvantages as described hereinbefore.

Another object of the present invention is to provide a novel and useful method for soldering to a printed-circuit board, electric and/or electronic components temporarily fixed thereto while preventing flux gases which are generated in soldering operation from accumulating around terminal portions of the components.

A still other object of the present invention is to provide a soldering method for soldering to the printed circuit board, electric and/or electronic components temporarily fixed thereto by blowing air or inert gas into the pool of molten solder and by striking bubbles against the board and the components during soldering operation.

In accordance with the present invention, there is provided a method of the above-mentioned kind comprising conveying printed circuit board having the components temporarily fixed thereto along the top of a pool of molten solder, generating bubbles by blowing gas into the molten solder, the bubbles rapidly rising in the molten solder toward its top, and striking the rising bubbles against the circuit surface to expel any flux gases which otherwise would accumulate around terminal portions of the components and to solder the components to the board.

In accordance with another embodiment of the present invention, there is provided a soldering method comprising conveying the printed-circuit board having chip components temporarily fixed thereto along the top of a pool of molten solder, supplying into the molten solder liquid under a predetermined pressure to evaporate it with heat of the molten solder, thereby producing vapor bubbles which rapidly rise in the molten solder toward its top, and striking the rising vapor bubbles against the chip components on the printed-circuit board to bring the molten solder into contact with the board and components and to expel any flux gases which otherwise would accumulate around terminal portions of the chip components.

In accordance with a still other embodiment of the present invention, there is provided a soldering method where during soldering operation, air bubbles are formed in the pool of molten solder by blowing compressed air thereinto and struck against the printed circuit board and the components temporarily fixed thereto which are conveyed along the top of the molten solder to effect soldering of the board and the components to each other and after soldering, inert gas is introduced into the molten solder to minimize its oxidation.

These and other objects and advantages of the present invention will become apparent from the following description made with reference to the accompanying drawings, in which

Figure 1 is a transversal cross-sectional view showing a first preferred embodiment of a soldering apparatus suitable to carry out a soldering method according to the present invention;

Figure 2 is a longitudinal cross-sectional view of the soldering apparatus as shown in Figure 1;

Figure 3 is a view similar to Figure 1 showing a second preferred embodiment of a soldering apparatus according to the present invention;

Figure 4 is a longitudinal cross-sectional view of the soldering apparatus as shown in Figure 3;

Figure 5 is a view similar to Figure 1 showing a third preferred embodiment of a soldering apparatus according to the present invention; and

Figure 6 is a longitudinal cross-sectional view of the soldering apparatus as shown in Figure 5.

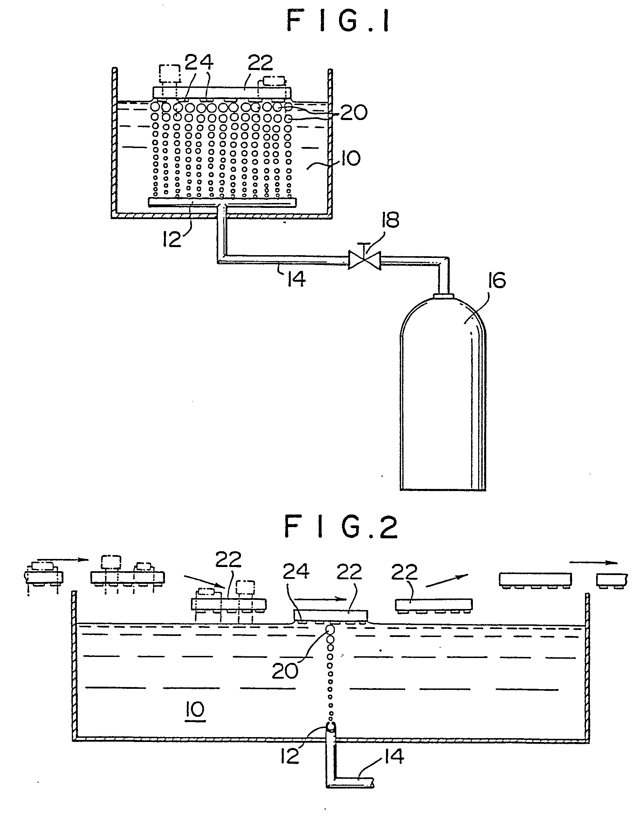

Referring to Figures 1 and 2 of the drawings, there is shown a first preferred embodiment of a soldering apparatus comprising a static pool of molten solder 10. A nozzle unit 12 is disposed in the pool of molten solder 10 adjacent its bottom and communicates through a pipe 14 with a gas cylinder 16 in which nitrogen gas is contained. A valve 18 is disposed in the pipe 14 for controlling a flow rate of the nitrogen gas from the gas cylinder 16 to the nozzle unit 12. The nitrogen gas from the cylinder 16 is blown through the nozzle unit 12 into the molten solder to form bubbles 20 which rise rapidly towards the top of the pool of molten solder and finally, burst at the top of the pool.

As will be seen in Figure 2, printed circuit boards 22 each having electric and/or electronic components including chip type components 24 temporarily bonded thereto in a conventional manner are conveyed along the top of the pool of molten solder 10. During movement of the printed circuit board 22 along the top of the pool, the rising bubbles 20 in the molten solder are struck against the printed circuit surface of the board 22 to burst at the top of the pool, thereby expelling any flux gases which otherwise would accumulate around terminal portions of the temporarily bonded chip components. Thus, the chip components are soldered to the printed circuit boards by uniformly contacting with the molten solder.

The soldering method according to the present invention may be applied to either a high speed jet flow type pool of molten solder or a flow type pool of molten solder to achieve excellent soldering of chip components to a printed circuit board.

Although the preferred embodiment of the present invention has been described hereinbefore in conjunction with the use of nitrogen gas, either air or any inert gas other than the nitrogen gas may be used for formation of gas bubbles in the molten solder. Particularly, the use of inert gas is effective to prevent the molten solder from being oxidized by gas to be blown into the molten solder. Thus, wasteful consumption of the molten solder can be prevented.

It will be understood from the foregoing that the present invention has provided a novel soldering method wherein in soldering to printed circuit board, electric and or electronic components temporarily bonded thereto using a static pool of molten solder, the board and components can be uniformly dipped in the molten solder by striking bubbles against the components to expel any flux gases out of the terminal portions of the components. According to the present invention, any need for formation of conventional vent holes in the printed circuit board can be eliminated and this makes it possible to make a highly concentrated circuit on the board.

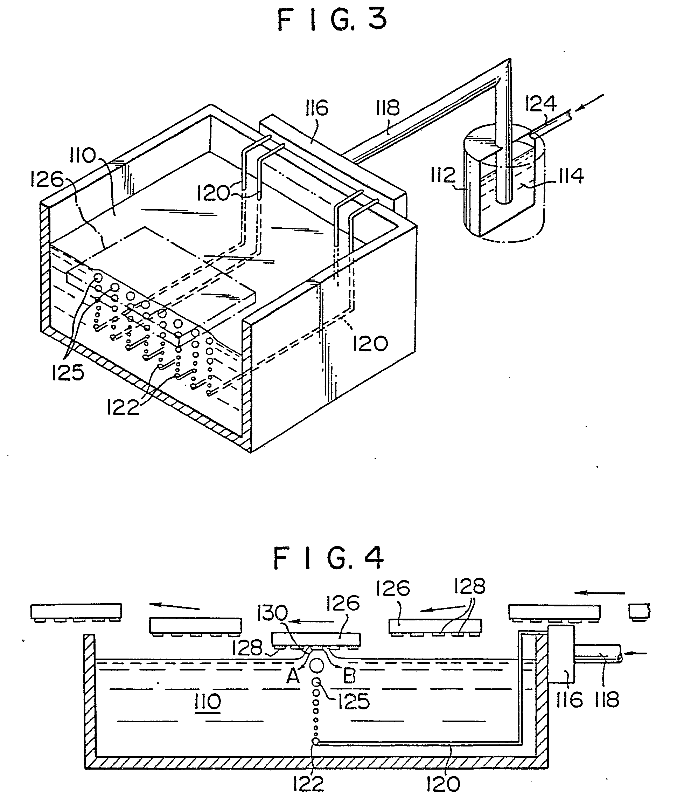

Referring to Figures 3 and 4 of the drawings, there is shown a second embodiment of a soldering apparatus comprising a static pool of molten solder 100. A container 112 contains liquid 114, such as organic solvent or water which can evaporate at the temperature of molten solder (240°C—270°C). A distributor 116 is connected to a supply conduit 118 which is in communication with the interior of the container 112. A plurality of nozzle tubes 120 extend from the distributor 116 into the molten solder adjacent the bottom of the pool of molten solder and are provided with nozzles 122 to blow the liquid 114 from the container into the molten solder. The container 112 is connected through an inlet conduit 124 to a source (not shown) from which compressed air is applied to the liquid 114 in the container at a predetermined pressure to deliver the liquid through the supply conduit 118 and distributor 116 to the nozzle tubes 120. Thus, the liquid 114 is introduced through the nozzles 122 into the molten solder so that it is evaporated in the molten solder with its heat to form bubbles 125 which rapidly rise towards printed circuit boards 126 which are conveyed along the top of the pool of molten solder and have electric and/or electronic components 128 including chip type components temporarily bonded thereto. The rising bubbles 125 are struck against the components 128 and the board 126 to bring the molten solder into contact with terminal portions of the components thereby achieving uniform soldering. As will be seen in Figure 4, raised portions 130 of molten solder are formed at its top by the rising bubbles so that the molten solder flows in the raised portions 130 in directions as indicated by arrows A and B to expel any gases such as gas from the board and flux gas which are generated during soldering operation and tend to accumulate around the terminal portions of the components. Molecular gas in the form of the bubbles formed by evaporation of the liquid serves to prevent any oxidation of the molten solder so that production of undesirable solder dross is reduced. Particularly, alcohols which become reducing gas in evaporation are suitable to minimize production of solder dross.

Flux solution which consists of flux dissolved in organic solvent or water may be used as liquid 114 which is introduced into the molten solder for formation of bubbles. In this case, flux to be required for soldering can be supplied in the form of bubbles through the pool of molten solder onto the printed circuit board and their components so that a fluxer and preheater which has been required heretofore prior to soldering can be omitted. Moreover, the flux solution serves to prevent any oxidation of the molten solder which may take place by formation of bubbles in the molten solder. The molten solder is covered at its top with the flux gas to prevent the molten solder from being oxidized by contacting with the atmosphere.

The liquid may be evaporated during its passage in the nozzle tubes so that it is blown in the form of vapor through the nozzles into the molten solder. This can be achieved by either employing nozzle tubes of any suitable heat- resisting material having a high heat conductivity or controlling flow of the liquid in the nozzle tubes.

It will be understood from the foregoing that according to the present invention there is provided a novel soldering method wherein liquid under pressure is introduced into a pool of molten solder to evaporate with heat of the molten solder, thereby forming bubbles which rapidly rises towards a printed circuit board with electric and/or electronic components temporarily fixed thereto, and the rising bubbles are struck against the board and components to bring the molten solder into contact with the board and components. Thus, any flux gas and gas generating from the board which would affect soldering of the components to the printed circuit board can be expelled out of the terminal portions of the components by striking the bubbles against them to achieve excellent soldering. Moreover, according to the present invention, generation of solder dross can be minimized.

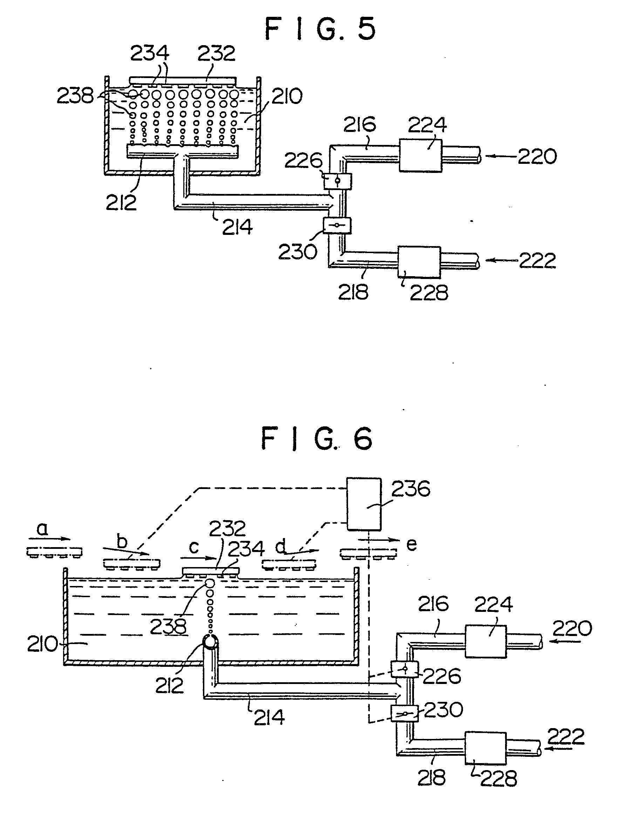

Referring to Figures 5 and 6 of the drawings, there is shown a bubble type pool of molten solder 210 according to a third preferred embodiment of the present invention which comprises a nozzle unit 212 disposed in the pool of molten solder for blowing gases thereinto. The nozzle unit 212 is connected to a pipe 214 at its forward end and at the other end, the pipe 214 is connected to an air supply line 216 and an inert gas supply line 218 which are connected to a source of compressed air 220 and a gas cylinder 222 containing inert gas such as nitrogen gas, respectively. The air supply line 216 includes a regulator 224 for regulating flow of the compressed air from the source 220 and an electromagnetic valve 226 for controlling supply of the compressed air through the pipe 214 to the nozzle unit 212. The inert gas supply line 218 includes a regulator 228 for regulating flow of the inert gas from the cylinder 222 and an electromagnetic valve 230 for controlling supply of the inert gas through the pipe 214 to the nozzle unit 212.

Printed circuit board 232 having electric and/or electronic components 234 including chip type components temporarily fixed thereto is conveyed along the top of the pool of molten solder 210, following a path as indicated by arrows a, b, c, d and e in Figure 6 of the drawings.

A device 236 is provided for detecting a position b of the circuit board 232 approaching the top of the molten solder before soldering and a position d of the board 232 leaving from the top of the molten solder after soldering to electrically actuate the electromagnetic valves 226 and 230. When the detecting device 236 electrically senses the board 232 at the position b, the electromagnetic valve 226 is opened to supply the compressed air from its source 20 to the nozzle unit 12 whereas the electromagnetic valve 230 is closed. When the device 236 senses the board 232 at its position d, the electromagnetic valve 226 is closed whereas the electromagnetic valve 230 is opened to supply the inert gas from its cylinder 222 to the nozzle unit 12.

The soldering apparatus is operated as follows:

As the printed circuit board 232 is conveyed from its position a to the approaching position b, detecting device 236 electrically senses the board 232 at position b to actuate the electromagnetic valve 226 from is closed position to an open position while keeping the electromagnetic valve 230 closed. Then, compressed air from the air supply line 216 and pipe 214 is blown through the nozzle unit 212 into the molten solder to form air bubbles 238 which rapidly rise toward the top of the molten solder. The rising air bubbles are struck against the printed circuit board 232 with the chip components 234 temporarily bonded thereto, which is conveyed from the approaching position b to a soldering position c where the chip components 234 are uniformly soldered to the circuit board 232 under the action of the rising air bubbles 238 without spreading out any molten solder through apertures (not shown) in the board. After soldering, the board 232 is conveyed from the soldering position c to the leaving position d where the detecting device 236 electrically senses existence of the board 232 to close the valve 226 for interruption of the supply of air and to open the valve 230 for introduction of inert gas from its cylinder 222 through the gas supply line 218, pipe 214 and nozzle unit 212 into the molten solder. The introduction of the inert gas into the molten solder causes any air remaining in the pipe 214 to expel out of the pipe 214 and the nozzle unit 212, thereby preventing the molten solder from being oxidized in the nozzle unit 212 and removing any solder dross accumulated on the nozzle unit 212. When the inert gas has been introduced through the nozzle unit 212 into the molten solder a predetermined time, the valve 230 is closed for interruption of the supply of the inert gas by actuating it through a timer (not shown) in the detecting device 236. Alternatively, introduction of the inert gas into the molten solder may be continued until air begins to be blown into the molten solder for soldering. Although in the preferred embodiment as shown in the drawings, it has been described that the inert gas is introduced into the molten solder when the board is in the leaving position d, the introduction of the inert gas may be begun immediately after the soldering has been completed.

It will be understood from the foregoing that there has been provided a soldering method wherein in soldering to a printed circuit board, electric and/or electronic components temporarily fixed thereto using a bubble type pool of molten solder, compressed air is introduced into the molten solder during soldering to form air bubbles which rapidly rise in the molten solder toward its top, the rising bubbles are struck against the board and components to solder them to each other, and after soldering, the supply of air is interrupted while inert gas is introduced into the molten solder. According to the present invention, production of undesirable solder dross can be reduced by blowing air into the molten solder for a short time to be required for soldering. Moreover, any air remaining in the pipe and the nozzle unit after interruption of the supply of air thereto is expelled into the molten solder by introducing the inert gas through the pipe and the nozzle unit into the molten solder to minimize production of undesirable solder dross in the nozzle unit.

**Claims**

1. A soldering method comprising a step of conveying printed circuit boards (22, 126, 232) with electric and/or electronic components (24, 128, 234) temporarily fixed thereto along the top of a pool of molten solder (10, 110, 210), characterized in that it further comprises steps of generating bubbles (20, 238) by blowing gas into the molten solder, the bubbles rapidly rising in the molten solder toward its top, and striking the rising bubbles against components and the board to achieve soldering of the components to the board.

2. A soldering method as claimed in claim 1 characterized in that said bubbles (20, 238) are generated by blowing inert gas into the molten solder.

3. A soldering method as claimed in claim 1 characterized in that said bubbles (20, 238)are generated by blowing air into the molten solder.

4. A soldering method comprising a step of conveying printed circuit boards (22, 126, 232) with electric and/or electronic components (24, 128, 234) temporarily fixed thereto along the top of a pool of molten solder (10, 110, 210), characterized in that it further comprises steps of introducing liquid (114) into the molten solder at a predetermined pressure to evaporate the liquid with heat of the molten solder, thereby forming bubbles which rapidly rise towards the board and the components, and striking the rising bubbles against the board and the components to bring the molten solder into contact with the board and components.

5. A soldering method as claimed in claim 4 characterized in that the board (126) with the components (128) temporarily fixed thereto is dipped into the molten solder (110) while the bubbles are being struck against the board and the component.

6. A soldering method as claimed in claim 4 characterized in that the upward movement of said bubbles causes the molten solder to be raised at its top (130) and the board (126) and the components (128) temporarily fixed thereto are exposed to said raised portions of molten solder.

7. A soldering method as claimed in claim 4 characterized in that said liquid consists of organic solvent such as alcohols, flux solution, or water.

8. A soldering method for soldering to a printed circuit board (232), electric and/or electronic components (234) temporarily fixed thereto using a bubble type pool of molten solder (210), characterized by the steps of introducing compressed air into the molten solder during soldering to form air bubbles which rapidly rise in the molten solder toward its top, striking the rising air bubbles against the board (232) and components (234) to achieve soldering of them to each other, interrupting the supply of compressed air after soldering and subsequently introducing inert gas into the molten solder.

9. A soldering apparatus comprising a pool of molten solder (10, 210), characterized by nozzle means (12, 212) disposed in the pool of molten solder, a source of gas (16, 220, 222), and means (14, 18, 214—228) for blowing the gas from the source through the nozzle means into the molten solder to form bubbles which rapidly rise in the molten solder toward the board and components for soldering.

10. A soldering apparatus comprising a pool of molten solder (110), characterized by nozzle means (122) disposed in the pool of molten solder, a container (112) containing liquid (114), and means (124, 118, 116) for delivering the liquid under pressure from said container through said nozzle means into the molten solder to evaporate the liquid with heat of the molten solder, thereby forming bubbles which rise towards the board and the components.

11. A soldering apparatus as claimed in claim 10 characterized in that said nozzle means (122) includes a plurality of nozzle tubes (120) in communication with said container (112) and said liquid is evaporated with heat of the molten solder during its passage in said nozzle tubes.

**Patentansprüche**

1. Lötverfahren, bei dem man gedruckte Schaltplatten (22, 126, 232) mit daran provisorisch befestigten elektrischen und/oder elektronischen Bauteilen (24, 128, 234) längs der Oberseite eines Bades aus geschmolzenem Lötmittel (10, 110, 210) bewegt, dadurch gekennzeichnet, daß man ferner Blasen (20, 238) erzeugt, indem ein Gas in das geschmolzene Lötmittel geblasen wird, wobei die Blasen rasch in dem geschmolzenen Lötmittel zur Oberseite aufsteigen, und daß man die aufsteigenden Blasen auf die Bauteile und die Platte auftreffen läßt, um ein Verlöten der Bauteile mit der Platte zu erzielen.

2. Lötverfahren nach Anspruch 1, dadurch gekennzeichnet, daß die Blasen (20, 238) durch Einblasen eines inerten Gases in das geschmolzene Lötmittel erzeugt werden.

3. Lötverfahren nach Anspruch 1, dadurch gekennzeichnet, daß die Blasen (20, 238) durch Einblasen von Luft in das geschmolzene Lötmittel erzeugt werden.

4. Lötverfahren, bei dem man eine gedruckte Schaltplatte (22, 126, 232) mit daran provisorisch befestigten elektrischen und/oder elektronischen Bauteilen (24, 128, 234) längs der Oberseite eines Bades aus geschmolzenem Lötmittel (10, 110, 210) bewegt, dadurch gekennzeichnet, daß man ferner eine Flüssigkeit (114) in das geschmolzene Lötmittel unter einem bestimmten Druck einführt, wobei die Flüssigkeit unter der Wärme des geschmolzenen Lötmittels verdampft und hierdurch Blasen gebildet werden, die rasch gegen die Platte und die Bauteile aufsteigen, und daß man die aufsteigenden Blasen auf die Platte und die Bauteile auftreffen läßt, um das geschmolzene Lötmittel in Berührung mit der Platte und den Bauteilen zu bringen.

5. Lötverfahren nach Anspruch 4, dadurch gekennzeichnet, daß die Platte (126) mit den provisorisch daran befestigten Bauteilen (128) in das geschmolzene Lötmittel (110) eingetaucht wird, während man die Blasen auf die Platte und die Bauteile auftreffen läßt.

6. Lötverfahren nach Anspruch 4, dadurch gekennzeichnet, daß die Aufwärtsbewegung der Blasen ein Anheben des geschmolzenen Lötmittels an seiner Oberseite (130) bewirkt und die Platte (126) sowie die daran provisorisch befestigten Bauteile (128) den angehobenen Stellen des Lötmittels ausgesetzt werden.

7. Lötverfahren nach Anspruch 4, dadurch gekennzeichnet, daß die Flüssigkeit aus einem organischen Lösungsmittel, wie Alkoholen, einem Flußmittel oder Wasser besteht.

8. Lötverfahren zum Verlöten einer gedruckten Schaltplatte (232) und elektrischer und/oder elektronischer provisorisch an der Schaltplatte befestigter Bauteile (234) unter Vorsehen eines Blasenbades aus geschmolzenem Lötmittel (210), dadurch gekennzeichnet, daß man Druckluft in das geschmolzene Lötmittel während des Lötens einführt, um Luftblasen zu bilden, die rasch in dem geschmolzenen Lötmittel zur Oberseite aufsteigen, daß man die aufsteigenden Luftblasen auf die Platte (232) und die Bauteile (234) auftreffen läßt, damit diese Teile miteinander verlötet werden, daß man die Zufuhr der Druckluft nach dem Löten unterbricht, und daß mam anschließend ein inertes Gas in das geschmolzene Lötmittel einführt.

9. Lötvorrichtung mit einem Bad aus geschmolzenem Lötmittel (10, 210), gekennzeichnet durch eine Düseneinrichtung (12, 212), die in dem Bad aus dem geschmolzenen Lötmittel angeordnet ist, eine Gasquelle (16, 220, 222) und eine Einrichtung (14, 18, 214—228) zum Einblasen des von der Quelle stammenden Gases über die Düseneinrichtung in das geschmolzene Lötmittel, so daß darin Blasen gebildet werden, die rasch in dem geschmolzenen Lötmittel gegen die Platte und die zu verlötenden Bauteile aufsteigen.

10. Lötvorrichtung mit einem Bad aus geschmolzenem Lötmittel (110), gekennzeichnet durch eine in dem Bad aus dem geschmolzenen Lötmittel angeordnete Düseneinrichtung (122), einen eine Flüssigkeit (114) enthaltenden Behälter (112) und eine Einrichtung (124, 118, 116) zur Abgabe der Flüssigkeit unter Druck aus dem Behälter über die Düseneinrichtung in das geschmolzene Lötmittel, so daß die Flüssigkeit unter der Hitze des geschmolzenen Lötmittels verdampft und dadurch Blasen gebildet werden, die gegen die Platte und die Bauteile aufsteigen.

11. Lötvorrichtung nach Anspruch 10, dadurch gekennzeichnet, daß die Düseneinrichtung (122) eine Vielzahl von Düsenrohren (120) umfaßt, die mit dem Behälter (112) in Verbindung stehen, und daß die Flüssigkeit unter der Hitze des geschmolzenen Lötmittels während des Durchganges durch die Düsenrohre verdampft wird.

**Revendications**

1. Méthode de soudage comportant une étape dans laquelle des cartes à circuit imprimé (22, 126, 232) auxquelles des composants électriques et/ou électroniques (24, 128, 234) sont temporairement fixés sont transportées le long du sommet d'un bain de soudure fondue (10, 110, 210), caractérisée en ce qu'elle comporte en outre des étapes de génération de bulles (20, 238) par insufflation de gaz dans la soudure fondue, de montée rapide des bulles dans la soudure fondue, vers le sommet de celle-ci, et de percussion des bulles ascendantes contre les composants et la carte pour réaliser le soudage des composants à la carte.

2. Méthode de soudage selon la revendication 1, caractérisée en ce que lesdites bulles (20, 238) sont générées par insufflation de gaz inerte dans la soudure fondue.

3. Méthode de soudage selon la revendication 1, caractérisée en ce que lesdites bulles (20, 238) sont générées par insufflation d'air dans la soudure fondue.

4. Méthode de soudage comportant une étape dans laquelle des cartes à circuit imprimé (22, 126, 232) auxquelles des composants électriques et/ou électroniques (24, 128, 234) sont temporairement fixés transportées, le long du sommet d'un bain de soudure fondue (10, 110, 210), caractérisée en ce qu'elle comporte en outre des étapes d'introduction de liquide (114) dans la soudure fondue, à une pression prédéterminée, pour évaporer le liquide par la chaleur de la soudure fondue, en formant ainsi des bulles qui montent rapidement vers la carte et les composants, et de percussion des bulles ascendantes contre la carte et les composants pour mettre la soudure fondue au contact de la carte et des composants.

5. Méthode de soudage selon la revendication 4, caractérisée en ce que la carte (126) avec les composants (128) qui y sont temporairement fixés est trempée dans la soudure fondue (110) tandis que les bulles sont heurtées contre la carte et le composant.

6. Méthode de soudage selon la revendication 4, caractérisée en ce que le mouvement ascensionnel desdites bulles provoque le soulèvement du sommet (130) de la soudure fondue, et la carte (126) et les composants (128) qui lui sont temporairement fixés sont exposés auxdites parties de soudure fondue soulevée.

7. Méthode de soudage selon la revendication 4, caractérisée en ce que ledit liquide est constitué de solvant organique tel qu'alcools, solution de flux, ou eau.

8. Méthode de soudage pour souder, à une carte (232) à circuit imprimé, des composants électriques et/ou électroniques (234) temporairement fixés à cette carte, en utilisant un bain de soudure fondue (210), du type à bulles, caractérisée par les étapes d'introduction d'air comprimé dans la soudure fondue, cela au cours de soudage, pour former des bulles d'air qui montent rapidement dans la soudure fondue, vers le sommet de celle-ci, de percussion des bulles d'air ascendantes contre la carte (232) et les composants (234) pour réaliser leur soudage mutuel, et d'interruption de la fourniture d'air comprimé après soudage, puis d'introduction de gaz inerte dans la soudure fondue.

9. Dispositif de soudage comportant un bain de soudure fondue (10, 210), caractérisé par des moyens d'ajutage (12, 212) disposés dans le bain de soudure fondue, une source de gaz (16, 220, 222) et des moyens (14, 18, 214—228) pour insuffler dans la soudure fondue, via la moyens d'ajutage, le gaz provenant de la source pour former des bulles qui montent rapidement dans la soudure fondue vers la carte et les composants, pour souder.

10. Dispositif de soudage comportant un bain de soudure fondue (110), caractérisé par des moyens d'ajutage (122) disposés dans le bain de soudure fondue, un récipient (112) contenant du liquide (114) et des moyens (124, 118, 116) pour délivrer, par lesdits moyens d'ajutage, dans la soudure fondue, le liquide sous pression provenant dudit récipient, pour le faire évaporer par la chaleur de la soudure fondue, formant ainsi des bulles qui montent vers la carte et les composants.

11. Dispositif de soudage selon la revendication 10, caractérisé en ce que lesdits moyens d'ajutage (122) comportent une pluralité de tubes (120) avec ajutages, en communication avec ledit récipient (112), et, au cours de son passage dans lesdits tubes avec ajutages, ledit liquide est évaporé par de la chaleur de la soudure fondue.

0 045 909

# F I G . I

# F I G . 2

1

# F I G. 3

# F I G. 4

# F I G. 5

# F I G. 6

3